(19) Europäisches Patentamt
European Patent Office
Office européen des brevets

(11) **EP 4 629 505 A1**

(12) **DEMANDE DE BREVET EUROPEEN**

(43) Date de publication:
**08.10.2025 Bulletin 2025/41**

(21) Numéro de dépôt: **25165450.5**

(22) Date de dépôt: **21.03.2025**

(51) Classification Internationale des Brevets (IPC):
**H03F 1/14** (2006.01)   **H03F 1/56** (2006.01)
**H03F 3/195** (2006.01)   **H03F 1/22** (2006.01)

(52) Classification Coopérative des Brevets (CPC):
**H03F 3/195; H03F 1/14; H03F 1/223; H03F 1/56;**
H03F 2200/534; H03F 2200/541; H03F 2200/72;
H03F 2200/75; H03F 2200/87; H03F 2203/45018;
H03F 2203/45141; H03F 2203/45318;
H03F 2203/45562

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité:   **03.04.2024   FR 2403403**

(71) Demandeur: **STMicroelectronics International
N.V.**
**1228 Plan-les-Ouates, Geneva (CH)**

(72) Inventeurs:
• **ROUX, Jocelyn**
  **38570 Hurtières (FR)**
• **MARGALEF ROVIRA, Marc**
  **38000 Grenoble (FR)**
• **PAILLARDET, Frederic**
  **73100 Tresserve (FR)**

(74) Mandataire: **Cabinet Beaumont**
**4, Place Robert Schuman**
**B.P. 1529**
**38025 Grenoble Cedex 1 (FR)**

(54) **AMPLIFICATEUR RADIOFREQUENCE**

(57)     La présente description concerne un amplificateur (100). Un premier transistor (Mcg1) couple un premier noeud d'entrée (In1) à un premier noeud de sortie (Out1). Un deuxième transistor (Mcg2) couple un deuxième noeud d'entrée (In2) à un deuxième noeud de sortie (Out2). Les bornes de commande des premier et deuxième transistors sont connectées. Un troisième transistor (Mcs1) a une borne de commande connectée au premier noeud d'entrée et une borne de conduction connectée au deuxième noeud de sortie. Un quatrième transistor (Mcs1) a une borne de commande connectée au deuxième noeud d'entrée et une borne de conduction connectée au premier noeud de sortie. Un circuit (CTRL1) commande un courant (I1, I2 ; It) dans les premier et deuxième transistors (Mcg1, Mcg2). Un circuit (CTRL2) fournit un signal de commande aux bornes de commande des premier et deuxième transistors (Mcg1, Mcg2).

Fig 1

EP 4 629 505 A1

**Description**

Domaine technique

La présente description concerne de façon générale les circuits électroniques, par exemple les circuits électroniques intégrés, et, plus particulièrement, les circuits radiofréquences configurés pour opérer à des fréquences par exemple comprises entre 3 kHz et 300 GHz, de préférence entre 1 GHz et 100 GHz.

Technique antérieure

De nombreux circuits électroniques radiofréquences comprennent des amplificateurs radiofréquences configurés pour recevoir un signal radiofréquence entre deux noeuds d'entrée de l'amplificateur, et pour fournir un signal radiofréquence amplifié correspondant entre deux noeuds de sortie de l'amplificateur.

Résumé de l'invention

Il existe un besoin de pallier tout ou partie des inconvénients des amplificateurs radiofréquence connus.
Par exemple, il serait souhaitable de disposer d'un amplificateur radiofréquence dans lequel le gain et l'impédance d'entrée de l'amplificateur puissent être réglés de manière indépendante l'un par rapport à l'autre.
Par exemple, il serait souhaitable de disposer d'un amplificateur radiofréquence adapté à des applications basses tensions, par exemple des applications où l'amplificateur reçoit une tension d'alimentation nominale sensiblement égale à 1,8 V.
Par exemple, il serait souhaitable de disposer d'un amplificateur radiofréquence ayant de bonnes conditions de stabilité.
Par exemple, il serait souhaitable de disposer d'un amplificateur radiofréquence présentant une bonne isolation entre ses deux noeuds d'entrée et ses deux noeuds de sortie.
Un mode de réalisation pallie tout ou partie des inconvénients des amplificateurs radiofréquences connus.
Un mode de réalisation prévoit un amplificateur comprenant :

un premier noeud d'entrée et un deuxième noeud d'entrée ;
un premier noeud de sortie et un deuxième noeud de sortie ;
un premier transistor couplant le premier noeud d'entrée au premier noeud de sortie ;
un deuxième transistor identique au premier, couplant le deuxième noeud d'entrée au deuxième noeud de sortie, les premier et deuxième transistors ayant leurs bornes de commande connectées entre elles ;
un troisième transistor ayant une borne de commande connectée au premier noeud d'entrée et une première borne de conduction connectée au deuxième noeud de sortie ;
un quatrième transistor identique au troisième, ayant une borne de commande connectée au deuxième noeud d'entrée et une première borne de conduction connectée au premier noeud de sortie ;
un premier circuit configuré pour commander un courant circulant dans les premier et deuxième transistors ; et un deuxième circuit configuré pour commander un signal de commande appliqué aux bornes de commande des premier et deuxième transistors.

Selon un mode de réalisation, un rapport entre une valeur d'une capacité entre les bornes de conduction de chacune des premier et deuxième transistors et une valeur de capacité entre la borne de commande et la première borne de conduction de chacun des troisième et quatrième transistors est compris entre 0.8 et 1.2, de préférence entre 0.9 et 1.1, par exemple égal à 1.
Selon un mode de réalisation :

chacun des troisième et quatrième transistors a une deuxième borne de conduction connectée à un noeud d'application d'un premier potentiel d'alimentation ; et
chacun des premier et deuxième noeuds de sortie est couplé à un noeud d'application d'un deuxième potentiel d'alimentation.

Selon un mode de réalisation, une première inductance couple le premier noeud de sortie au noeud d'application du deuxième potentiel d'alimentation et une deuxième inductance couple le deuxième noeud de sortie au noeud d'application du deuxième potentiel d'alimentation.
Selon un mode de réalisation, les première et deuxième inductances constituent un enroulement primaire d'un transformateur.

Selon un mode de réalisation, une capacité a une première borne connectée à un noeud de connexion des bornes de commande des premier et deuxième transistors entre elles.

Selon un mode de réalisation, la capacité a une borne deuxième connectée au noeud d'application du premier potentiel d'alimentation.

Selon un mode de réalisation, l'amplificateur comprend un noeud sommateur configuré pour recevoir la somme des courants circulant dans les premier et deuxième transistors, les premier et deuxième noeuds d'entrée étant couplés chacun au noeud sommateur.

Selon un mode de réalisation, une troisième inductance couple le premier noeud d'entrée au noeud sommateur et une quatrième inductance couple le deuxième noeud d'entrée au noeud sommateur.

Selon un mode de réalisation, les troisième et quatrième inductances constituent un enroulement secondaire d'un transformateur.

Selon un mode de réalisation :

- le premier circuit comprend un transistor connecté entre le noeud sommateur et le noeud d'application du premier potentiel d'alimentation ;
- le premier circuit comprend un circuit de commande configuré pour fournir, à une borne de commande dudit transistor, un signal déterminant la valeur du courant dans ledit transistor ; et
- le transistor connecté entre le noeud sommateur et le noeud d'application du premier potentiel d'alimentation est, de préférence, deux fois plus gros que chacun des premier et deuxième transistors.

Selon un mode de réalisation, le circuit de commande du premier circuit comprend un transistor et une source de courant connectés en série entre les noeuds d'application des premier et deuxième potentiels d'alimentation, ledit transistor étant monté en miroir avec le transistor connecté entre le noeud sommateur et le noeud d'application du premier potentiel d'alimentation.

Selon un mode de réalisation, le deuxième circuit comprend :

un amplificateur d'erreur ayant une première entrée connectée au noeud sommateur et une sortie couplée aux bornes de commande des premier et deuxième transistors de sorte à y appliquer le signal de commande des premier et deuxième transistors ; et

un circuit de commande configuré pour fournir un signal de consigne à la deuxième entrée de l'amplificateur d'erreur.

Selon un mode de réalisation, le circuit de commande du deuxième circuit comprend une source de courant et un transistor connectés en série entre les noeuds d'application des premier et deuxième potentiels d'alimentation, ledit transistor ayant une borne de commande connectée à la deuxième entrée de l'amplificateur d'erreur et à un noeud de connexion dudit transistor à ladite source de courant.

Selon un mode de réalisation :

un rapport de dimension entre le transistor du circuit de commande du premier circuit et le transistor connecté entre le noeud sommateur et le noeud d'application du premier potentiel d'alimentation détermine, avec une valeur du courant de la source de courant du circuit de commande du premier circuit, une valeur du courant dans chacun des premier et deuxième transistors ; et

un rapport de dimension entre le transistor du circuit de commande du deuxième circuit et le transistor connecté entre le noeud sommateur et le noeud d'application du premier potentiel d'alimentation détermine, avec une valeur du courant de la source de courant du circuit de commande du deuxième circuit, une valeur d'un signal de commande de chacun des premier et deuxième transistors.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de manière schématique et en partie sous la forme de blocs, un exemple de mode de réalisation d'un amplificateur radiofréquence ;

la figure 2 représente, de manière schématique et en partie sous la forme de blocs, un exemple plus détaillé de mode de réalisation d'un amplificateur radiofréquence ;

la figure 3 représente, de manière schématique, un exemple de mode de réalisation d'une partie d'un circuit de l'amplificateur de la figure 2 ;

la figure 4 représente, de manière schématique, un exemple de mode de réalisation d'une partie d'un autre circuit de l'amplificateur de la figure 2 ;

la figure 5 illustre par des courbes un réglage du gain de l'amplificateur des figures 1 et 2 ; et

la figure 6 illustre par des courbes un réglage de l'impédance d'entrée de l'amplificateur des figures 1 et 2 ; et

la figure 7 illustre par des courbes l'isolation entre les noeuds d'entrée et les noeuds de sortie et la stabilité de l'amplificateur des figures 1 et 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les divers circuits, applications et systèmes électroniques connus dans lesquels un amplificateur radiofréquence est mis en œuvre n'ont pas été détaillés, les modes de réalisation et variantes décrits étant compatible avec ces circuits, applications et systèmes électroniques connus.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

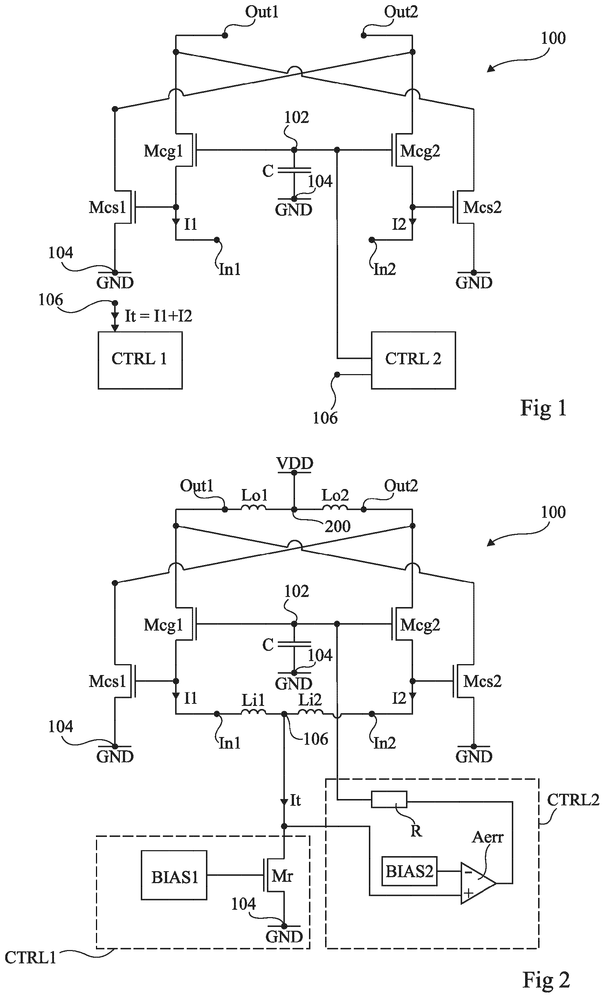

La figure 1 représente, de manière schématique et en partie sous la forme de blocs, un exemple de mode de réalisation d'un amplificateur radiofréquence 100.

L'amplificateur 100 comprend deux noeuds d'entrée In1 et In2. L'amplificateur 100 est configuré pour recevoir un signal d'entrée à amplifier entre les noeuds In1 et In2. Par exemple, le signal d'entrée appliqué entre les noeuds In1 et In2 est un signal différentiel.

L'amplificateur 100 comprend en outre deux noeuds de de sortie Out1 et Out2. L'amplificateur 100 est configuré pour fournir un signal de sortie amplifié entre les noeuds Out1 et Out2. Par exemple, le signal de sortie disponible entre les noeuds Out1 et Out2 est un signal différentiel.

L'amplificateur 100 comprend une paire de transistors Mcg1 et Mcg2 identiques.

Dans cet exemple, les transistors Mcg1 et Mcg2 sont des transistors MOS (de l'anglais "Metal Oxide Semiconductor"

-   Métal Oxyde Semiconducteur). Dans cet exemple, les transistors Mcg1 et Mcg2 sont montés chacun en grille commune.

L'amplificateur 100 est, par exemple, alimenté par une tension d'alimentation définie par une différence entre un premier potentiel d'alimentation GND, par exemple la masse, et un deuxième potentiel d'alimentation VDD. Dans cet exemple, le potentiel VDD est positif par rapport au premier potentiel d'alimentation, et les transistors Mcg1 et Mcg2 sont alors à canal N.

Le transistor Mcg1 couple le noeud In1 au noeud Out1. Par exemple, le transistor Mcg1 a une première borne de conduction, par exemple son drain, couplée, de préférence connectée, au noeud Out1 et une deuxième borne de conduction, par exemple sa source, couplée, de préférence connectée, au noeud In1.

De manière symétrique, le transistor Mcg2 couple le noeud In2 au noeud Out2. Par exemple, le transistor Mcg2 a une première borne de conduction, par exemple son drain, couplée, de préférence connectée, au noeud Out2 et une deuxième borne de conduction, par exemple sa source, couplée, de préférence connectée, au noeud In2.

Les transistors Mcg1 et Mcg2 sont commandés de manière identique, par un circuit de commande CTRL2. Ainsi, selon un mode de réalisation, les transistors Mcg1 et Mcg2 ont leurs bornes de commande, par exemple leurs grilles, connectées l'une à l'autre.

De préférence, une capacité C, par exemple une capacité de lissage, est connectée à un noeud 102 de connexion des bornes de commande des transistors Mcg1 et Mcg2 entre elles. Par exemple, la capacité C a une borne connectée au noeud 102, l'autre borne de la capacité C étant, par exemple, connectée à un noeud 104 configuré pour recevoir le premier potentiel d'alimentation GND.

L'amplificateur 100 comprend une autre paire de transistors Mcs1 et Mcs2 identiques.

De préférence, les transistors Mcs1 et Mcs2 sont des transistors de la même technologie que les transistors Mcg1 et Mcg2, à savoir des MOS dans cet exemple.

En outre, les transistors Mcs1 et Mcs2 sont des transistors du même type que les transistors Mcg1 et Mcg2, à savoir des transistors MOS à canal N dans cet exemple.

Dans cet exemple, les transistors Mcs1 et Mcs2 sont montés chacun en source commune.

Le transistor Mcs1 a une borne de commande, par exemple sa grille, connectée au noeud In1, ou, dit autrement, à la deuxième borne de conduction du transistor Mcg1. En outre, le transistor Mcs1 a une première borne de conduction, par exemple sa source, connectée au noeud 104.

De manière symétrique, le transistor Mcs2 a une borne de commande, par exemple sa grille, connectée au noeud In2, ou, dit autrement, à la deuxième borne de conduction du transistor Mcg2. En outre, le transistor Mcs2 a une première borne de conduction, par exemple sa source, connectée au noeud 104.

Les transistors Mcs1 et Mcs2 ont leurs deuxièmes bornes de conductions, par exemple leurs drains, couplés aux noeuds respectifs Out2 et Out1. Par exemple, la deuxième borne de conduction du transistor Mcs1 est connectée au noeud Out2, la deuxième borne de conduction du transistor Mcs2 étant connectée au noeud In1.

L'amplificateur 100 comprend en outre un circuit CTRL1. Le circuit CTRL1 est configuré pour commander un courant I1, respectivement I2, circulant dans le transistor Mcg1, respectivement Mcg2. Les courants I1 et I2 sont, en pratique, des courants continus (DC de l'anglais "direct current"), ou, dit autrement, des courants de polarisation. Plus particulièrement, l'amplificateur 100 et son circuit CTRL1 sont configurés pour les courants I1 et I2 soient égaux.

Par exemple, l'amplificateur 100 est configuré pour que les transistors MOS Mcs1, Mcs2, Mcg1 et Mcg2 soient polarisés dans leurs zones de saturation.

Pour une valeur donnée des courants I1 et I2 commandée par le circuit CTRL1, une modification de la valeur du signal de commande appliqué aux bornes de commande des transistors Mcg1 et Mcg2 par le circuit CTRL2 entraine une modification du gain de l'amplificateur. En effet, la modification du signal de commande des transistors Mcg1 et Mcg2 pour une valeur donnée des courants I1, I2 entraîne une modification du signal sur la borne de commande des transistors Mcs1 et Mcs2, donc une modification du gain de l'amplificateur. Cette modification du gain de l'amplificateur 100 n'entraîne pas de modification significative de l'impédance d'entrée de l'amplificateur 100. Par exemple, pour une modification de 5 dB du gain de l'amplificateur 100, l'impédance d'entrée de l'amplificateur 100 est modifiée de moins de 50 ohms, par exemple de moins de 30 ohms.

A titre d'exemple, le circuit CTRL2 régule le signal de commande des transistors Mcg1 et Mcg2 à une valeur déterminée par une valeur cible de gain de l'amplificateur.

De manière symétrique, pour une valeur donnée du signal de commande appliqué aux bornes de commande des transistors Mcg1 et Mcg2 par le circuit CTRL2, une modification de la valeur des courants I1 et I2 par le circuit CTRL1 entraîne une modification de l'impédance d'entrée de l'amplificateur 100. Cette modification de l'impédance d'entrée de l'amplificateur 100 n'entraîne pas de modification significative du gain de l'amplificateur 100. Par exemple, pour une modification par un facteur 2 de l'impédance d'entrée de l'amplificateur 100, le gain de l'amplificateur 100 est modifié de moins de 2 dB, par exemple de moins de 1 dB.

A titre d'exemple, le circuit CTRL1 régule les courants I1 et I2 à une valeur déterminée par une valeur cible d'impédance d'entrée de l'amplificateur.

L'amplificateur 100 permet donc un réglage indépendant de son gain et de son impédance d'entrée.

Selon un mode de réalisation, les noeuds Out1 et Out2 sont couplés chacun à un noeud (non représenté en figure 1) d'application du potentiel VDD.

A titre d'exemple, le noeud Out1 est couplé au potentiel VDD par une inductance, et le noeud Out2 est couplé au potentiel VDD par une autre inductance.

A titre d'exemple, ces deux inductances peuvent être constitutives de l'enroulement primaire d'un transformateur configuré pour recevoir le signal de sortie de l'amplificateur.

A titre d'autre exemple, les deux inductances ne font pas partie d'un transformateur, et chacun des noeuds Out1 et Out2 est en outre couplé au noeud 104 par une capacité correspondante. Dans ce cas, deux composantes alternatives (AC de l'anglais "Alternate Current") d'un signal différentiel de sortie peuvent être reçues sur ces deux capacités.

A titre d'autre exemple, chacun des noeuds Out1 et Out2 peut être couplé au potentiel VDD de sorte à mettre en œuvre un couplage DC de chacun des noeuds Out1 et Out2 avec ce potentiel VDD.

Du fait que les transistors Mcs1 et Mcg1 ne sont pas connectés en série entre les potentiels VDD et GND, et, de manière symétrique, que les transistors Mcs2 et Mcg2 ne sont pas connectés en série entre les potentiels VDD et GND, ces transistors peuvent rester polarisés dans leurs zones de saturations avec des valeurs de potentiel VDD plus faibles que si ces transistors avaient été connectés en série. Ainsi, l'amplificateur 100 peut être utilisé dans des applications basses tensions.

Selon un mode de réalisation, les transistors Mcg1 et Mcs2 sont configurés pour que le rapport Cr entre la capacité entre les bornes de conduction du transistor Mcg1, en pratique une capacité intrinsèque du transistor Mcg1, par la capacité entre la borne de commande et la deuxième borne de conduction du transistor Mcs2, correspondant en pratique à une capacité intrinsèque du transistor Mcs2, soit compris entre 0.8 et 1.2, de préférence entre 0.9 et 1.1, par exemple égal à 1. Cela permet d'assurer de bonnes propriétés de stabilité à l'amplificateur 100 et, en outre, une bonne isolation entre ses noeuds d'entrée In1 et In2 et ses noeuds de sortie Out1 et Out1. Par exemple, cela permet d'obtenir un facteur K supérieur à 4, par exemple supérieur à 10 quand le rapport Cr est égal à 1, avec

$$K = (1 - \sqrt{|S11|} - \sqrt{|S22|} + \sqrt{|S11 * S22 - S12 * S21|})/$$

$(2 * |S12|*|S21|)$ où S11, S22, S12 et S21 sont les paramètres S de l'amplificateur 100. Par exemple, cela permet d'obtenir une isolation en puissance S12 en dB inférieure à -35 dB, par exemple inférieure à -44 dB quand le rapport Cr est égal à 1.

En pratique, choisir un rapport Cr compris dans les plages de valeurs ci-dessus, de préférence égal à 1, permet de mettre en œuvre un neutrodynage dans l'amplificateur 100 sans recourir à des capacités de liaison et à des transistors montés en capacité, donc sans augmenter la surface de l'amplificateur. On tire ici parti des capacités intrinsèques des transistors Mcs1, Mcs2, Mcg1, Mcg2.

Selon un mode de réalisation, les noeuds In1 et In2 sont couplés chacun à un noeud 106 de l'amplificateur 100. Le noeud 106 est un noeud de sommation de courant, configuré pour recevoir la somme It des courants I1 et I2. De préférence, les noeuds In1 et In2 ne sont pas directement connectés au noeud 106.

A titre d'exemple, le noeud In1 est couplé au noeud 106 par une inductance, et le noeud In2 est couplé au noeud 106 par une autre inductance.

A titre d'exemple, ces deux inductances peuvent être constitutives de l'enroulement secondaire d'un transformateur configuré pour appliquer le signal d'entrée de l'amplificateur.

A titre d'autre exemple, les deux inductances ne font pas partie d'un transformateur, et chacun des noeuds In1 et In2 est couplé au noeud 104 par une capacité correspondante. Dans ce cas, deux composantes alternatives (AC de l'anglais "Alternate Current") d'un signal différentiel d'entrée peuvent être appliquées sur ces deux capacités.

Selon un mode de réalisation, le circuit CTRL1 est connecté au noeud 106 et est configuré pour commander la valeur du courant It de sorte à commander la valeur des courants I1 et I2 à une valeur de consigne déterminant la valeur de l'impédance d'entrée de l'amplificateur 100. A titre d'exemple, le circuit CTRL1 couple le noeud 106 au noeud 104.

De préférence, le noeud 106 est également un noeud de polarisation configuré pour recevoir, par exemple du circuit CTRL1, un potentiel de polarisation continu.

A titre de variante (non illustrée), le circuit CTRL1 peut être configuré pour commander individuellement (ou indépendamment) les courants I1 et I2 dans les transistors Mcg1 et Mcg2, de sorte à ce que ces courants soient égaux.

Selon un mode de réalisation, le circuit CTRL2 est connecté au noeud 106 et est configuré pour commander, pour une valeur donnée des courants I1, I2, et donc It, le signal de commande des transistors Mcg1 et Mcg2 de sorte à commander, pour chacun des transistors Mcs1 et Mcs2, la valeur du signal de commande reçu par ce transistor, et donc la valeur du gain de l'amplificateur.

A titre d'exemple, le circuit CTRL2 est connecté au noeud 106 pour recevoir le potentiel du noeud 106, et est configuré pour commander les transistors Mcg1 et Mcg2 de sorte réguler le potentiel du noeud 106 à une valeur de commande déterminant la valeur du gain de l'amplificateur.

La figure 2 représente, de manière schématique et en partie sous la forme de blocs, un exemple plus détaillé de mode de réalisation de l'amplificateur radiofréquence 100.

L'amplificateur 100 de la figure 2 comprend de nombreux éléments en communs avec l'amplificateur 100 de la figure 1, et seules les différences entre ces amplificateurs sont ici mises en exergue. Ainsi, sauf indication contraire, tous ce qui a été indiqué en relation avec la figure 1 s'applique en figure 2.

Dans l'exemple d'amplificateur 100 de la figure 2, le noeud Out1, respectivement Out2, est couplé à un noeud 200 d'application du potentiel VDD par une inductance Lo1, respectivement Lo2. Les inductances Lo1 et Lo2 forment, par exemple, l'enroulement primaire d'un transformateur recevant le signal de sortie de l'amplificateur 100.

Dans l'exemple d'amplificateur 100 de la figure 2, le noeud In1, respectivement In2, est couplé au noeud 106 par une inductance Li1, respectivement Li2. Les inductances Li1 et Li2 forment, par exemple, l'enroulement secondaire d'un transformateur fournissant le signal d'entrée de l'amplificateur 100.

Dans l'exemple de mode de réalisation de la figure 2, le circuit CTRL1 de l'amplificateur 100 comprend un transistor Mr connecté, par ses bornes de conduction, entre les noeuds 106 et 104.

De préférence, le transistor Mr est en la même technologie que les transistors Mcg1 et Mcg2, et est par exemple un transistor MOS quand ces transistors Mcg1 et Mcg2 sont des transistors MOS.

De préférence, le transistor est du même type que les transistors Mcg1 et Mcg2, et est par exemple un transistor MOS à canal N quand ces transistors Mcg1 et Mcg2 sont des transistors MOS à canal N.

Par exemple, le transistor Mr a une première borne de conduction, par exemple sa source, couplée, de préférence connectée, au noeud 104, et une deuxième borne de conduction, par exemple son drain, couplée, de préférence connectée, au noeud 106.

De préférence, le transistor Mr est deux fois plus gros que les transistors Mcg1 et Mcg2.

Dans cet exemple de mode de réalisation, le circuit CTRL1 comprend en outre un circuit de commande BIAS1 du transistor Mr. Le circuit BIAS1 est configuré pour fournir un signal de commande déterminant la valeur du courant It dans le transistor Mr, donc la valeur des courants I1 et I2 dans les transistors respectifs Mcg1 et Mcg2. A titre d'exemple, la valeur du signal fourni par le circuit BIAS à la borne de commande du transistor Mr est déterminé par une valeur cible d'impédance d'entrée de l'amplificateur.

Le circuit CTRL2 est configuré pour réguler le potentiel DC du noeud 106, ou, dit autrement, les potentiels DC des noeuds In1 et In2, à une valeur de consigne déterminant le gain de l'amplificateur 100. Dans l'exemple de mode de réalisation de la figure 2, le circuit CTRL2 comprend un amplificateur d'erreur Aerr. L'amplificateur Aerr a une première entrée, par exemple non-inverseuse (+), couplée, de préférence connectée, au noeud 106. Le circuit CTRL2 comprend en outre un circuit de commande BIAS2 configuré pour fournir un signal de consigne à la deuxième entrée, par exemple inverseuse (-), de l'amplificateur d'erreur Aerr. La sortie de l'amplificateur d'erreur Aerr détermine la valeur du signal de commande fourni aux bornes de commande des transistors Mcg1, Mcg2. Par exemple, la sortie de l'amplificateur d'erreur Aerr est couplée au noeud 102, par exemple par un élément résistif R comme cela est représenté dans l'exemple de la figure 2.

On notera que la mise en œuvre du circuit CRTL1 telle que décrite en relation avec la figure 2 est indépendante de la mise en œuvre du circuit CTRL2 telle que décrite en relation avec la figure 2. Ainsi, le circuit CTRL1 peut être mis en œuvre de la manière décrite ci-dessus, sans que le circuit CTRL2 ne soit mis en œuvre de la manière décrite ci-dessus, et inversement.

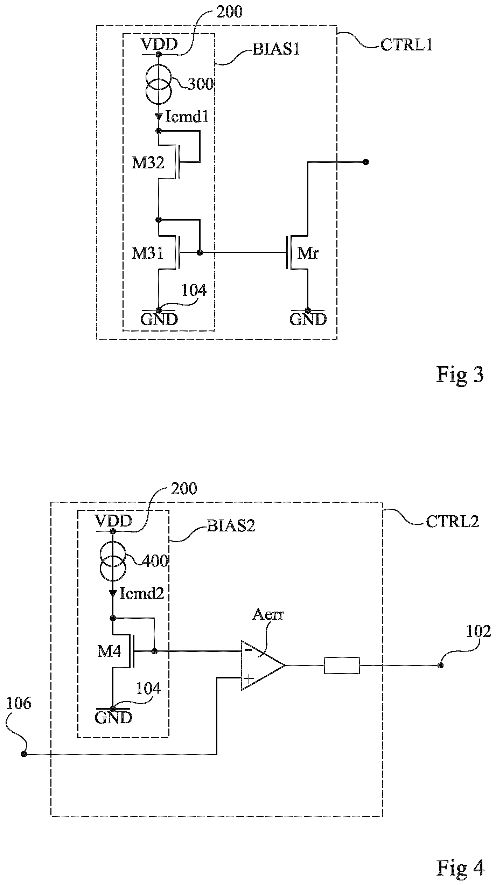

La figure 3 représente, de manière schématique, un exemple de mode de réalisation du circuit BIAS1 du circuit CTRL1 de l'amplificateur 100 de la figure 2, étant entendu que la personne du métier pourra prévoir d'autres mises en œuvre de ce circuit BIAS1, et plus généralement, du circuit CTRL1.

Dans cet exemple de mode de réalisation, le circuit BIAS1 comprend une source de courant 300 et un transistor M31 connectés en série entre les noeuds 104 et 200. Le transistor M31 est monté en miroir du transistor Mr. Par exemple, le transistor M31 a une première borne de conduction connectée au noeud 104, une deuxième borne de conduction couplée à la source de courant 300 et une borne de commande connectée à sa deuxième borne de conduction.

Le transistor M31 est de la même technologie et du même type que le transistor Mr, et est, dans cet exemple, un transistor MOS à canal N. Par exemple sa source est connectée au noeud 104 et son drain est couplé à la source de courant 300 et connecté à la grille du transistor M31.

Dans l'exemple de la figure 3, le transistor M31 est couplé à la source de courant 300 par un transistor M32 monté en diode. Le transistor M32 est, de préférence, de la même technologie et du même type que le transistor M31, et est, dans cet exemple, un transistor MOS à canal N. Par exemple, une première borne de conduction du transistor M32, dans cet exemple sa source, est connectée à la deuxième borne de conduction du transistor M31, dans cet exemple son drain, et une deuxième borne de conduction du transistor M32, par exemple son drain, est connectée à une borne de la source de courant 300, l'autre borne de la source de courant 300 étant connectée au noeud 200.

La source de courant 300 est configurée pour fournir un courant Icmd1 de commande. La valeur du courant Icmd1 détermine, avec un rapport de dimension des transistors M31 et Mr, la valeur des courants I1 et I2, donc de l'impédance d'entrée de l'amplificateur 100. A titre d'exemple, le circuit BIAS1 est configuré pour que le courant It soit égal à A fois le courant Icmd1, avec A un facteur positif, et le rapport des dimensions du transistor M31 sur le rapport des dimensions du transistor Mr est égal à A. Par exemple, lorsque le transistor Mr est deux fois plus gros que chacun des transistors Mcg1 et Mcg2, le transistor M31 est 2A fois plus gros que chacun des transistors Mcg1 et Mcg2.

La figure 4 représente, de manière schématique, un exemple de mode de réalisation du circuit BIAS2 du circuit CTRL2 de l'amplificateur 100 de la figure 2, étant entendu que la personne du métier pourra prévoir d'autres mises en œuvre de ce circuit BIAS2, et plus généralement, du circuit CTRL2.

Dans cet exemple de mode de réalisation, le circuit BIAS2 comprend une source de courant 400 et un transistor M4 connectés en série entre les noeuds 104 et 200. Le transistor M4 a une borne de commande connectée à la deuxième entrée, par exemple inverseuse (-), de l'amplificateur d'erreur Aerr. En outre, le transistor M4 est monté en diode, et a sa borne de commande connectée à un noeud de connexion du transistor M4 à la source de courant 400.

De préférence, le transistor M4 est de la même technologie et du même type que le transistor Mr, et est, dans cet exemple, un transistor MOS à canal N. Par exemple sa source est connectée au noeud 104 et son drain est couplé, par exemple connecté, à la source de courant 400 et à la grille du transistor M4.

La source de courant 400 est configurée pour fournir un courant Icmd2 de commande. La valeur du courant Icmd2 détermine, avec le dimensionnement du transistor M4, la valeur du signal de consigne fourni à l'amplificateur Aerr, ou, dit plus généralement, la valeur du signal de commande des transistors Mcg1 et Mgc2, donc du gain de l'amplificateur 100.

Par exemple, lorsque le circuit CTRL1 comprend le transistor Mr entre les noeuds 106 et 104, un rapport de dimension entre le transistor M4 et le transistor Mr détermine, avec une valeur du courant Icmd2, une valeur d'un signal de commande de chacun des transistors Mcg1 et Mcg2, donc, pour une valeur donnée des courants I1 et I2, une valeur d'un signal de commande de chacun des transistors Mcs1 et Mcs2. A titre d'exemple, le circuit BIAS2 est configuré pour que le potentiel du noeud de connexion du transistor M4 à la source de courant 400 détermine la valeur du potentiel du noeud 106.

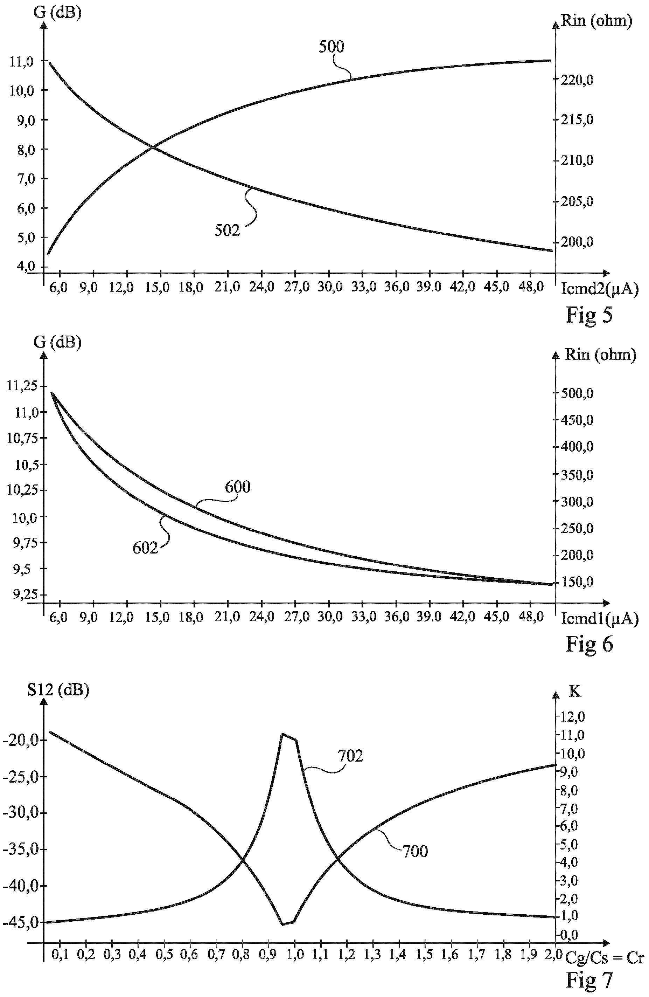

La figure 5 illustre par des courbes 500 et 502 un exemple de réglage du gain de l'amplificateur 100. Dans cet exemple, les courbes 500 et 502 sont obtenues avec les circuits CTRL1 et CTRL2 mis en œuvre de la façon décrite en relation avec les figures 2 à 4, en particulier en ce qui concerne les circuits BIAS1 et BIAS2.

La courbe 500 illustre l'évolution du gain G, en dB, de l'amplificateur 100 en fonction d'une valeur de consigne, cette valeur de consigne correspondant ici à la valeur du courant Icmd2, en μA. La courbe 502 illustre l'évolution de l'impédance d'entrée Rin, en ohms, de l'amplificateur 100 en fonction d'une valeur de consigne, ici la valeur du courant Icmd2.

La courbe 500 montre que, en faisant varier la valeur de consigne du circuit CTRL2, c'est à dire ici la valeur du courant Icmd2, par exemple entre 6 μA et 48 μA, il est possible de régler la valeur du gain G, par exemple de faire varier la valeur du gain G entre 4,5 dB et 11 dB.

En outre, la courbe 502 montre que ce réglage du gain G par le circuit CTRL2 ne modifie pas de manière significative la valeur de l'impédance d'entrée Rin. Dit autrement, quand le gain G varie d'un dB, l'impédance d'entrée Rin varie de moins de 10%, de préférence de moins 5 %.

Par exemple, lorsque la valeur de consigne du circuit CTRL2, c'est à dire la valeur du courant Icmd2, varie entre 6 μA et 48 μA, la valeur du gain G varie entre 4,5 dB et 11 dB, alors que l'impédance d'entrée Rin reste comprise entre 225 et 198 ohms.

La figure 6 illustre par des courbes 600 et 602 un exemple de réglage de l'impédance d'entrée Rin de l'amplificateur 100. Dans cet exemple, les courbes 600 et 602 sont obtenues avec les circuits CTRL1 et CTRL2 mis en œuvre de la façon décrite en relation avec les figures 2 à 4, en particulier en ce qui concerne les circuits BIAS1 et BIAS2.

La courbe 600 illustre l'évolution du gain G, en dB, de l'amplificateur 100 en fonction d'une valeur de consigne, cette valeur de consigne correspondant ici à la valeur du courant Icmd1, en μA. La courbe 602 illustre l'évolution de l'impédance d'entrée Rin, en ohms, de l'amplificateur 100 en fonction d'une valeur de consigne, ici la valeur du courant Icmd1.

La courbe 602 montre que, en faisant varier la valeur de consigne du circuit CTRL1, c'est à dire ici la valeur du courant Icmd1, par exemple entre 6 μA et 48 μA, il est possible de régler la valeur de l'impédance d'entrée Rin, par exemple de faire varier la valeur de l'impédance Rin entre 150 et 500 ohms.

En outre, la courbe 600 montre que ce réglage de l'impédance Rin par le circuit CTRL1 ne modifie pas de manière significative la valeur du gain G. Par exemple, quand l'impédance Rin varie d'un facteur 2, le gain G varie de moins de 2 dB, de préférence de moins de 1 dB. Dit autrement, quand l'impédance Rin varie, par exemple, de 100 ohms, le gain G varie de moins de 1 dB.

Par exemple, lorsque la valeur de consigne du circuit CTRL1, c'est à dire la valeur du courant Icmd1, varie entre 6 μA et 48 μA, la valeur de l'impédance d'entrée Rin varie entre 150 et 500 ohms, alors que le gain G reste compris entre 9,25 et 11,25 dB.

La figure 7 illustre par des courbes l'évolution de l'isolation en puissance S12, en dB, entre les noeuds In1, In2 et les noeuds Out1, Out2 (courbe 700) et de la stabilité K de l'amplificateur 100 (courbe 702), en fonction de l'évolution du rapport entre la capacité intrinsèque Cg entre la source et le drain du transistor Mcg1, respectivement Mcg2, et la capacité intrinsèque Cs entre la grille et le drain du transistor Mcs1, respectivement Mcs2.

Les courbes 700 et 702 montrent que, plus le rapport Cg/Cs est proche de 1, meilleures sont la stabilité et l'isolation dans l'amplificateur 100.

Par exemple, les courbes 700 et 702 montrent que, pour un rapport Cg/Cs compris entre 0.8 et 1.2, l'isolation S12 est inférieure à -35 dB, c'est à dire a des valeurs négatives supérieures, en valeur absolue, à 35, et que la valeur du facteur de stabilité K est supérieure à 4.

Par exemple, les courbes 700 et 702 montrent que, pour un rapport Cg/Cs compris entre 0.8 et 1.1, l'isolation S12 est inférieure à -42 dB, c'est à dire a des valeurs négatives supérieures, en valeur absolue, à 42, et que la valeur du facteur de stabilité K est supérieure à 7,5.

Par exemple, les courbes 700 et 702 montrent que, pour un rapport Cg/Cs égal à 1, l'isolation S12 est égale à -45 dB et que la valeur du facteur de stabilité K est égale à 10,5.

Ainsi, cela a déjà été indiqué précédemment, les transistors Mcg1, Mcg2, Mcs1 et Mcs2 sont configurés pour que le rapport Cr entre la capacité intrinsèque entre les bornes de conduction de chacun des transistors Mcg1, Mcg2, par la capacité intrinsèque entre la borne de commande et la deuxième borne de conduction de chacun des transistors Mcs1 et Mcs2, soit compris entre 0.8 et 1.2, de préférence entre 0.9 et 1.1, par exemple égal à 1.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, dans les exemples décrits, les transistors sont en technologie MOS et sont de type à canal N. Toutefois, la personne du métier sera en mesure d'adapter la description faite ci-dessus de ces exemples, au cas où le potentiel VDD est négatif par rapport au potentiel GND, par exemple en remplaçant tous les transistors MOS à canal N par des transistors MOS à canal P.

Plus généralement, la personne du métier sera en mesure d'adapter la description faite ci-dessus d'exemples dans lesquels les transistors sont en technologie MOS a des cas où les transistors sont en technologie bipolaire, par exemple tous de type PNP ou tous de type NPN selon que le potentiel VDD soit positif ou négatif par rapport au potentiel GND, voire même à des transistors en technologie BiCMOS.

Enfin, la mise en oeuvre pratique des modes de réalisation et variantes décrits est à la portée de la personne du métier à partir des indications fonctionnelles données ci-dessus.

**Revendications**

**1.**   Amplificateur (100) comprenant :

un premier noeud d'entrée (In1) et un deuxième noeud d'entrée (In2) ;
un premier noeud de sortie (Out1) et un deuxième noeud de sortie (Out2) ;
un premier transistor (Mcg1) couplant le premier noeud d'entrée au premier noeud de sortie ;
un deuxième transistor (Mcg2) identique au premier,
couplant le deuxième noeud d'entrée au deuxième noeud de sortie, les premier et deuxième transistors (Mcg1, Mgc2) ayant leurs bornes de commande connectées entre elles ;
un troisième transistor (Mcs1) ayant une borne de commande connectée au premier noeud d'entrée (In1) et une première borne de conduction connectée au deuxième noeud de sortie (Out2) ;
un quatrième transistor (Mcs1) identique au troisième,
ayant une borne de commande connectée au deuxième noeud d'entrée (In2) et une première borne de conduction connectée au premier noeud de sortie (Out1) ;
un premier circuit (CTRL1) configuré pour commander un courant (I1, I2 ; It) circulant dans les premier et deuxième transistors (Mcg1, Mcg2) ; et
un deuxième circuit (CTRL2) configuré pour commander un signal de commande appliqué aux bornes de commande des premier et deuxième transistors (Mcg1, Mcg2).

**2.**   Amplificateur selon la revendication 1, dans lequel un rapport (Cr) entre une valeur d'une capacité (Cg) entre les bornes de conduction de chacune des premier et deuxième transistors (Mcg1, Mcg2) et une valeur de capacité (Cs) entre la borne de commande et la première borne de conduction de chacun des troisième et quatrième transistors (Mcs1, Mcs2) est compris entre 0.8 et 1.2, de préférence entre 0.9 et 1.1, par exemple égal à 1.

**3.**   Amplificateur selon la revendication 1 ou 2, dans lequel :

chacun des troisième et quatrième transistors (Mcs1, Mcs2) a une deuxième borne de conduction connectée à un noeud (104) d'application d'un premier potentiel d'alimentation (GND) ; et
chacun des premier et deuxième noeuds de sortie (Out1, Out2) est couplé à un noeud (200) d'application d'un deuxième potentiel d'alimentation (VDD).

**4.**   Amplificateur selon la revendication 3, dans lequel une première inductance (Lo1) couple le premier noeud de sortie (Out1) au noeud d'application (200) du deuxième potentiel d'alimentation et une deuxième inductance (Lo2) couple le deuxième noeud de sortie (Out2) au noeud (200) d'application du deuxième potentiel d'alimentation.

**5.**   Amplificateur selon la revendication 4, dans lequel les première et deuxième inductances (Lo1, Lo2) constituent un enroulement primaire d'un transformateur.

**6.**   Amplificateur selon l'une quelconque des revendications 3 à 5, dans lequel une capacité (C) a une première borne connectée à un noeud (102) de connexion des bornes de commande des premier et deuxième transistors (Mcg1, Mcg2) entre elles.

7. Amplificateur selon la revendication 6, dans lequel la capacité (C) a une deuxième borne connectée au noeud (104) d'application du premier potentiel d'alimentation (GND).

8. Amplificateur selon l'une quelconque des revendications 3 à 7, dans lequel l'amplificateur (100) comprend un noeud sommateur (106) configuré pour recevoir la somme (It) des courants (I1, I2) circulant dans les premier et deuxième transistors (Mcg1, Mcg2), les premier et deuxième noeuds d'entrée (In1, In2) étant couplés chacun au noeud sommateur (106).

9. Amplificateur selon la revendication 8, dans lequel une troisième inductance (Li1) couple le premier noeud d'entrée (In1) au noeud sommateur (106) et une quatrième inductance (Li2) couple le deuxième noeud d'entrée (In2) au noeud sommateur (106).

10. Amplificateur selon la revendication 9, dans lequel les troisième et quatrième inductances (Li1, Li2) constituent un enroulement secondaire d'un transformateur.

11. Amplificateur selon l'une quelconque des revendications 8 à 10, dans lequel :

- le premier circuit (CTRL1) comprend un transistor (Mr) connecté entre le noeud sommateur (106) et le noeud (104) d'application du premier potentiel d'alimentation (GND) ;
- le premier circuit (CTRL1) comprend un circuit de commande (BIAS1) configuré pour fournir, à une borne de commande dudit transistor (Mr), un signal déterminant la valeur du courant (It) dans ledit transistor (Mr) ; et
- le transistor (Mr) connecté entre le noeud sommateur (106) et le noeud (104) d'application du premier potentiel d'alimentation est, de préférence, deux fois plus gros que chacun des premier et deuxième transistors (Mcg1, Mcg2).

12. Amplificateur selon la revendication 11, dans lequel le circuit de commande (BIAS1) du premier circuit (CTRL1) comprend un transistor (MM31) et une source de courant (300) connectés en série entre les noeuds (200, 104) d'application des premier et deuxième potentiels d'alimentation (VDD, GND), ledit transistor (M31) étant monté en miroir avec le transistor (Mr) connecté entre le noeud sommateur (106) et le noeud (104) d'application du premier potentiel d'alimentation (GND).

13. Amplificateur selon l'une quelconque des revendications 8 à 12, dans lequel le deuxième circuit (CTRL2) comprend :

un amplificateur d'erreur (Aerr) ayant une première entrée connectée au noeud sommateur (106) et une sortie couplée aux bornes de commande des premier et deuxième transistors (Mcg1, Mcg2) de sorte à y appliquer le signal de commande des premier et deuxième transistors (Mcg1, Mcg2) ; et
un circuit de commande (BIAS2) configuré pour fournir un signal de consigne à la deuxième entrée de l'amplificateur d'erreur (Aerr).

14. Amplificateur selon la revendication 13, dans lequel le circuit de commande (BIAS2) du deuxième circuit (CTRL2) comprend une source de courant (400) et un transistor (M4) connectés en série entre les noeuds (200, 104) d'application des premier et deuxième potentiels d'alimentation (VDD, GND), ledit transistor (M4) ayant une borne de commande connectée à la deuxième entrée de l'amplificateur d'erreur (Aerr) et à un noeud de connexion dudit transistor (M4) à ladite source de courant (400).

15. Amplificateur selon la revendication 14 prise dans sa dépendance à la revendication 11, dans lequel :

un rapport de dimension entre le transistor (M31) du circuit de commande (BIAS1) du premier circuit (CTRL1) et le transistor (Mr) connecté entre le noeud sommateur (106) et le noeud (104) d'application du premier potentiel d'alimentation (GND) détermine, avec une valeur du courant (Icmd1) de la source de courant (300) du circuit de commande (BIAS1) du premier circuit (CTRL1), une valeur du courant (I1, I2 ; It) dans chacun des premier et deuxième transistors (Mcg1 Mcg2) ; et
un rapport de dimension entre le transistor (M4) du circuit de commande (BIAS2) du deuxième circuit (CTRL2) et le transistor (Mr) connecté entre le noeud sommateur (106) et
le noeud (104) d'application du premier potentiel d'alimentation (GND) détermine, avec une valeur du courant (Icmd2) de la source de courant (400) du circuit de commande (BIAS2) du deuxième circuit (CTRL2), une valeur d'un signal de commande de chacun des premier et deuxième transistors (Mcg1, Mcg2).

Fig 1

Fig 2

Fig 3

Fig 4

Fig 5

Fig 6

Fig 7

Europäisches
Patentamt

European
Patent Office

Office européen
des brevets

**RAPPORT DE RECHERCHE EUROPEENNE**

Numéro de la demande

EP 25 16 5450

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2022/094313 A1 (MOHAMMADNEZHAD SEYED MOHAMMAD HOSSEIN [US] ET AL) 24 mars 2022 (2022-03-24) | 1,3,4, 8-10 | INV. H03F1/14 H03F1/56 |
| A | * alinéa [0057] - alinéa [0075]; figure 5A * | 2,5-7, 11-15 | H03F3/195 H03F1/22 |
| | ----- | | |
| X | SI XIONG ET AL: "A dual-band 2.1GHz/5.2GHz LNA for reconfigurable radio", SOLID-STATE AND INTEGRATED CIRCUIT TECHNOLOGY (ICSICT), 2010 10TH IEEE INTERNATIONAL CONFERENCE ON; 20101101 - 20101104, IEEE, PISCATAWAY, NJ, USA, 1 novembre 2010 (2010-11-01), pages 710-712, XP031835018, ISBN: 978-1-4244-5797-7 | 1,3,4,6 | |
| A | * section 2 entitled: "Circuit Design"; page 1 - page 2; figure 1 * | 2,5,7-15 | |
| | ----- | | |
| X | US 2012/286874 A1 (KIM NAMSOO [US] ET AL) 15 novembre 2012 (2012-11-15) * alinéa [0044]; figure 9B * | 1,3,4,6, 7 | DOMAINES TECHNIQUES RECHERCHES (IPC) |
| | ----- | | H03F |
| Y | CN 117 792 295 A (ZUNPAI COMMUNICATION TECH NANJING CO LTD) 29 mars 2024 (2024-03-29) * La partie de la description correspondant à description des figures 1 à 3 et l'avant dernier paragraphe de la section intitulée "Detailed Ways" de la description avant la section "First embodiment".; figures 1-3 * | 1-12 | |
| | ----- | | |
| | -/-- | | |

Le présent rapport a été établi pour toutes les revendications

| Lieu de la recherche | Date d'achèvement de la recherche | Examinateur |
|---|---|---|
| La Haye | 24 mars 2025 | Wienema, David |

Europäisches
Patentamt

European
Patent Office

Office européen
des brevets

**RAPPORT DE RECHERCHE EUROPEENNE**

Numéro de la demande

EP 25 16 5450

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CN 107 592 079 A (CALTERAH SEMICONDUCTOR TECH SHANGHAI CO LTD) 16 janvier 2018 (2018-01-16) * La partie de la description correspondant à description des figures 1 et 6.; figures 1, 6 * | 1-12 | |
| A | US 2020/382076 A1 (KRISHNAMURTHI KATHIRAVAN [US]) 3 décembre 2020 (2020-12-03) * alinéa [0029] - alinéa [0040]; figure 3 * | 11,12 | |

-----

-----

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 24 mars 2025 | Wienema, David |

page 2 de 2

**ANNEXE AU RAPPORT DE RECHERCHE EUROPEENNE**
**RELATIF A LA DEMANDE DE BREVET EUROPEEN NO.**   EP 25 16 5450

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-03-2025

| Document brevet cité au rapport de recherche | Date de publication | Membre(s) de la famille de brevet(s) | Date de publication |
|---|---|---|---|
| US 2022094313 A1 | 24-03-2022 | CN 114257190 A | 29-03-2022 |
| | | CN 115149914 A | 04-10-2022 |
| | | US 11095334 B1 | 17-08-2021 |
| | | US 2022094313 A1 | 24-03-2022 |
| | | US 2023020706 A1 | 19-01-2023 |
| US 2012286874 A1 | 15-11-2012 | CN 103534940 A | 22-01-2014 |
| | | EP 2707951 A1 | 19-03-2014 |
| | | JP 6026514 B2 | 16-11-2016 |
| | | JP 2014513902 A | 05-06-2014 |
| | | KR 20140011402 A | 28-01-2014 |
| | | US 2012286874 A1 | 15-11-2012 |
| | | WO 2012158429 A1 | 22-11-2012 |
| CN 117792295 A | 29-03-2024 | AUCUN | |
| CN 107592079 A | 16-01-2018 | CN 107592079 A | 16-01-2018 |
| | | CN 112929001 A | 08-06-2021 |
| US 2020382076 A1 | 03-12-2020 | AUCUN | |

EPO FORM P0460

Pour tout renseignement concernant cette annexe : voir Journal Officiel de l'Office européen des brevets, No.12/82